# EUROPEAN PATENT APPLICATION

(11) **EP 4 832 721 A1**
(43) Date of publication of application: **28.10.2026**
(21) Application number: 26174069.0
(22) Date of filing: 22.04.2026
(51) Int. Cl.: H10K 59/35, H10K 59/121, H10K 59/123, H10K 59/131

(54) **DISPLAY DEVICE**

(30) Priority: 23.04.2025 KR 20250052856; 29.07.2025 KR 20250102844
(71) Applicant: LG Display Co., Ltd., Seoul 07336 (KR)
(72) Inventor: JUNG, Doyoung, 10845 Paju-si, Gyeonggi-do (KR); KIM, Jiah, 10845 Paju-si, Gyeonggi-do (KR); KIM, Juhan, 10845 Paju-si, Gyeonggi-do (KR); CHUNG, Euihyun, 10845 Paju-si, Gyeonggi-do (KR)
(74) Representative: Bryn-Jacobsen, Caelia

(57) **Abstract**

A display device comprises a display area (DA) in which a first pixel including a first sub-pixel, a second sub-pixel, a third sub-pixel, and an auxiliary driving part (SDP) of an auxiliary pixel (SDA) is disposed; and a non-display area (NDA) which is disposed around the display area and in which an auxiliary light emitting part of the auxiliary pixel is disposed, wherein the auxiliary light emitting part is electrically connected to the auxiliary driving part.

## Description

This application claims priority to and the benefit of Korean Patent Applications No. 10-2025-0052856 filed on April 23, 2025, and No. 10-2025-0102844 filed on July 29, 2025.

### BACKGROUND

### [Technical Field]

Examples of the present disclosure relate to a display device.

### [Background of the Disclosure]

As the information society develops, various demands for display devices for displaying images are increasing, and various types of display devices such as a liquid crystal display (LCD), an organic light emitting diode (OLED) display, and the like are being utilized.

The display device includes a plurality of pixels, and is provided with a plurality of switching elements to drive and control the pixels.

### SUMMARY

Accordingly, examples of the present disclosure have a technical object to provide a display device which is configured to reduce a non-display area without a decrease in resolution.

Examples of the present disclosure have a technical object to provide a display device which may reduce a non-display area while reducing pixel density of a display area.

Examples of the present disclosure have a technical object to provide a display device which may reduce a difference in image quality according to pixel density by reducing a difference in pixel density between a periphery and a center of a display area.

Examples of the present disclosure have a technical object to provide a display device in which a difference in image quality according to pixel density from the periphery to the center of the display area is reduced.

Examples of the present disclosure have a technical object to provide a low-power display device which is configured to realize high color reproduction by reducing the difference in image quality.

The objects of the present disclosure are not limited to those mentioned above, and other technical problems may be inferred from the following examples.

A display device according to an example for solving the above problems includes: a display area in which a first pixel including a first sub-pixel, a second sub-pixel, a third sub-pixel, and an auxiliary driving part of an auxiliary pixel is disposed; and a non-display area disposed around the display area, in which an auxiliary light emitting part of the auxiliary pixel is disposed, wherein the auxiliary light emitting part is electrically connected to the auxiliary driving part.

A display device according to an example for solving the above problems includes: a substrate including a display area and a non-display area around the display area; a first driving part of a first sub-pixel, a second driving part of a second sub-pixel, a third driving part of a third sub-pixel, and an auxiliary driving part of an auxiliary pixel, which are disposed in the display area; a first light emitting part of the first sub-pixel disposed on the first driving part and electrically connected to the first driving part; a second light emitting part of the second sub-pixel disposed on the second driving part and electrically connected to the second driving part; and a third light emitting part of the third sub-pixel disposed on the third driving part and electrically connected to the third driving part, wherein an auxiliary light emitting part of the auxiliary pixel is disposed in the non-display area, and the auxiliary light emitting part and the auxiliary driving part of the display area are electrically connected.

Specific details of other examples are included in the detailed description and the drawings.

Examples of the present disclosure may reduce a bezel area without a decrease in resolution by electrically connecting a driving part of an auxiliary pixel in a display area and a light emitting part positioned on an upper portion of a gate driving circuit.

Examples of the present disclosure may reduce pixel density of the display area by disposing the auxiliary pixel only in a region where a reduction of a non-display area is required.

Examples of the present disclosure may reduce a difference in image quality according to the pixel density between a periphery and a center of the display area by disposing the auxiliary pixels throughout the display area.

Examples of the present disclosure may reduce the difference in image quality according to the pixel density by reducing a displacement density of the auxiliary pixels from the periphery to the center of the display area.

Examples of the present disclosure may provide a low-power display device in which high color reproduction is realized by reducing the difference in image quality.

However, the effects that may be obtained in the present disclosure are not limited to the effects mentioned above, and other effects not mentioned will be clearly understood by those skilled in the art to which the present disclosure belongs from the following description.

### [Brief Description of the Drawings]

FIG. 1 is a plan view of a display device according to an example.
FIG. 2 is a view illustrating an enlarged view of a region Q1 of FIG. 1.
FIG. 3 is a view illustrating an enlarged view of the region Q1 of FIG. 1.
FIG. 4 is a view illustrating a circuit which is configured to constitute a driving part and a light emitting part of an auxiliary pixel.
FIG. 5 is a cross-sectional view illustrating a cross-section taken along line A-A' of FIG. 3.
FIG. 6 is a plan view of a display device according to an example.
FIG. 7 is a view illustrating an enlarged view of a region Q2 of FIG. 6.
FIG. 8 is a view illustrating an enlarged view of a region Q3 of FIG. 6.
FIG. 9 is a view for explaining a position of the auxiliary pixel according to an example.
FIG. 10 is a view for explaining a position of the auxiliary pixel according to an example.

### DETAILED DESCRIPTION OF SPECIFIC EXAMPLES

Hereinafter, examples will be described with reference to the drawings.

The same reference numerals refer to the same components. In addition, in the drawings, the thickness, ratio, and dimensions of components may be exaggerated for effective description of technical contents. The scale of the components shown in the drawings is different from the actual scale for convenience of description, and thus is not limited to the scale shown in the drawings.

In the present disclosure, when a component (or region, layer, part, etc.) is referred to as being "on," "connected to," or "coupled to" another component, it means that it may be directly connected/coupled to the other component or a third component may be disposed therebetween.

"And/or" includes all combinations of one or more that the associated configurations may define.

Although terms such as first and second may be used to describe various components, the components are not limited by the terms. The terms are used only for the purpose of distinguishing one component from another component. For example, a first component may be named a second component, and similarly, a second component may also be named a first component, without departing from the scope of examples of the present disclosure. The singular expression includes the plural expression unless the context clearly dictates otherwise.

Terms such as "below," "beneath," "above," and "upper" are used to describe the correlation of the configurations shown in the drawings. The terms are relative concepts and are described based on the directions indicated in the drawings. For example, unless "directly" or "immediately" is used, one or more other parts may be located between two parts. Spatially relative terms such as "below," "beneath," "lower," "above," and "upper" may be used to easily describe the correlation between one element or component and another element or component as shown in the drawings. Spatially relative terms should be understood as terms including different directions of the device in use or operation in addition to the direction shown in the drawings. For example, when a device shown in the drawings is turned over, a device described as "below" or "beneath" another device may be placed "above" the other device. Accordingly, the exemplary term "below" may include both downward and upward directions.

Terms such as "comprise" or "include" are intended to specify that features, numbers, steps, operations, components, parts, or combinations thereof described in the specification exist, and should be understood as not precluding the existence or addition possibility of one or more other features, numbers, steps, operations, components, parts, or combinations thereof.

Each of the features of various examples of the present disclosure may be partially or entirely coupled or combined with each other, and technically various interlocking and driving are possible, and each example may be implemented independently of each other or may be implemented together in a correlation.

Hereinafter, a display device of the present disclosure will be described through the accompanying drawings and examples.

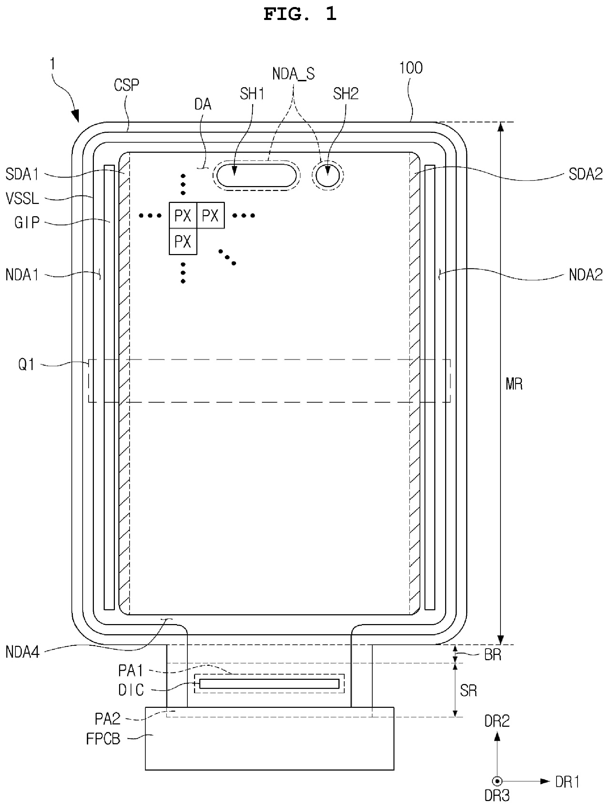

FIG. 1 is a plan view of a display device according to an example.

Referring to FIG. 1, a display device 1 according to an example may include a display panel 100. The display panel 100 may include a display area DA including a plurality of pixels PX, and a non-display area NDA or a bezel area around the display area DA. A planar shape of the display area DA may have a rectangular shape. However, it is not limited thereto, and the planar shape of the display area DA may be a square, a circle, an ellipse, or other polygons. For example, the display area DA may have a rectangular shape with rounded corners, but is not limited thereto, and may be a rectangle with angled corners.

In examples, a first direction DR1 and a second direction DR2 are different directions and are directions intersecting each other, for example, indicating directions intersecting perpendicularly on a plan view. In FIG. 1, the first direction DR1 may be generally the same as the extending direction of the short sides of the display panel 100, and the second direction DR2 may be the same as the extending direction of the long sides of the display panel 100. However, the directions mentioned in the examples should be understood as referring to relative directions, and the examples are not limited to the mentioned directions.

The display area DA may include short sides extending along the first direction DR1, and long sides extending along the second direction DR2. The non-display area NDA may surround the display area DA. The non-display area NDA may be disposed at one side (e.g. a left side) in the first direction DR1, the other side (e.g. a right side) in the first direction DR1, one side (e.g. an upper side) in the second direction DR2, and the other side (e.g. a lower side) in the second direction DR2 of the display area DA. For example, the non-display area NDA may include a first non-display area NDA1 disposed at one side of the display area DA in the first direction DR1, and a second non-display area NDA2 disposed at the other side of the display area DA in the first direction DR1. The first non-display area NDA1 and the second non-display area NDA2 may refer to regions including a gate driver GIP.

The display area DA may include an auxiliary pixel area SDA. The auxiliary pixel area SDA refers to a region in the display area DA where pixels PX including an auxiliary driving part SDP of an auxiliary pixel are disposed. For example, a plurality of pixels PX may be disposed in the display area DA, and a region where the pixels PX including the auxiliary driving part SDP among the pixels PX are disposed may be referred to as the auxiliary pixel area SDA.

The auxiliary pixel area SDA may include a first auxiliary pixel area SDA1 and a second auxiliary pixel area SDA2. The first auxiliary pixel area SDA1 may refer to a region disposed around the first non-display area NDA1, and the second auxiliary pixel area SDA2 may refer to a region disposed around the second non-display area NDA2.

The display device 1 may include a main area MR, a sub-area SR, and a bending area BR between the main area MR and the sub-area SR. The display area DA and the non-display area NDA surrounding the display area DA on four sides constitute the main area MR, and a portion extending farther away the other side (e.g. a lower side) in the second direction DR2from the center of the other side (e.g. a lower side) of the display area DA in the second direction DR2 may constitute the bending area BR and the sub-area SR. The bending area BR may be disposed between the sub-area SR and the main area MR. The sub-area SR may include a first pad area PA1 and a second pad area PA2 located at the end of the other side of the sub-area SR in the second direction DR2. The display device 1 may further include a data driver DIC and a flexible printed circuit board FPCB. The data driver DIC may be disposed in the first pad area PA1, and the printed circuit board FPCB may be attached to the second pad area PA2. In the first pad area PA1 and the second pad area PA2, a plurality of pads connected to the data driver DIC and the printed circuit board FPCB may be respectively disposed. The data driver DIC may be formed, for example, in the form of a driving chip IC, but is not limited thereto. In an example, a case where the data driver DIC is disposed in a chip-on-plastic manner in which it is directly mounted on the display panel 100 is illustrated, but it is not limited thereto, and it may be disposed in a chip-on-glass manner or a chip-on-film manner.

The display panel 100 according to an example may further include a crack sensing pattern CSP surrounding a low-potential voltage line VSSL. As shown in FIG. 1, the crack sensing pattern CSP may be disposed to completely surround the display area DA. For example, the crack sensing pattern CSP may be disposed outside the low-potential voltage line VSSL. However, examples of the present disclosure are not limited thereto, and the crack sensing pattern CSP may not be partially disposed in the non-display area NDA at the other side (e.g. a lower side) of the display area DA in the second direction DR2.

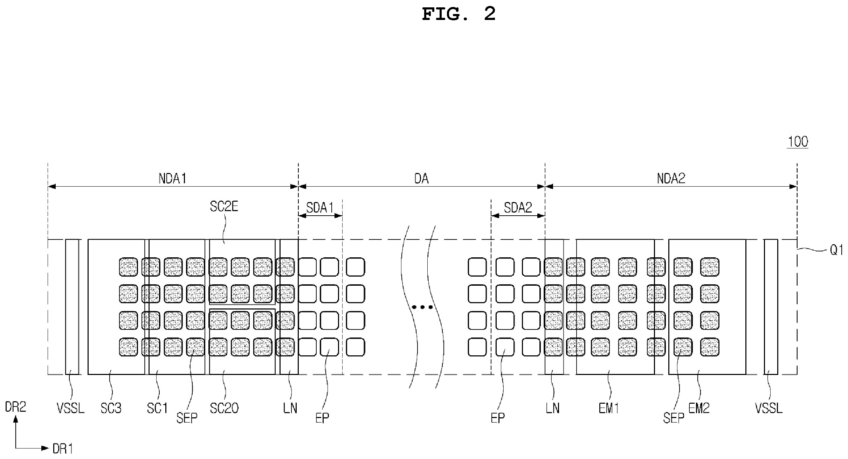

FIG. 2 is a view illustrating an enlarged view of a region Q1 of FIG. 1.

The gate driver GIP may include a first scan portion SC1, a second scan portion SC2, and a third scan portion SC3 which generate a gate signal, and may include a first output portion EM1 and a second output portion EM2 which transmit the generated gate signal to a gate line.

The first non-display area NDA1 may include the low-potential voltage line VSSL, the first scan portion SC1, the second scan portion (SC2E, SC2O), and the third scan portion SC3 of the gate driver GIP, and a connection portion LN including connection wires electrically connected between driving circuits such as the data driver DIC of the display panel 100 and internal circuits of the display panel 100.

The first scan portion SC1, the second scan portion (SC2E, SC2O), and the third scan portion SC3 of the gate driver GIP may be disposed between the low-potential voltage line VSSL and the connection portion LN. For example, the third scan portion SC3, the first scan portion SC1, and the second scan portion SC2 may be sequentially disposed in the first direction DR1 from the low-potential voltage line VSSL. At this time, the second scan portion SC2 may include a second scan portion SC2E controlling even signal lines and a second scan portion SC2O controlling odd signal lines, and they may be sequentially disposed along the second direction DR2.

The second non-display area NDA2 may include the low-potential voltage line VSSL, the first output portion EM1 and the second output portion EM2 of the gate driver GIP, and the connection portion LN.

The first output portion EM1 and the second output portion EM2 of the gate driver GIP may be disposed between the low-potential voltage line VSSL and the connection portion LN. For example, the first output portion EM1 and the second output portion EM2 may be sequentially disposed from the connection portion LN in the first direction DR1, but is not limited thereto, and they may also be disposed in the order of the connection portion LN, the second output portion EM2, the first output portion EM1, and the low-potential voltage line VSSL.

A pixel (refer to PX of FIG. 1) disposed in the display area DA of the display panel 100 may include a plurality of sub-pixels. The first sub-pixel may be a red sub-pixel, the second sub-pixel may be a green sub-pixel, and the third sub-pixel may be a blue sub-pixel, but examples of the present disclosure are not limited thereto. In some examples, the pixel PX further includes a fourth sub-pixel, and the fourth sub-pixel may be a white sub-pixel, but examples of the present disclosure are not limited thereto. In some examples, the pixel PX may include one red sub-pixel, two green sub-pixels, and one blue sub-pixel, but examples of the present disclosure are not limited thereto. For example, the plurality of sub-pixels may be arranged in a stripe manner along the first direction DR1, but is not limited thereto, and may also be arranged in a Pentile manner.

The sub-pixels may include a driving part DP and a light emitting part EP electrically connected to the driving part DP. For example, the first sub-pixel may include a first driving part DP1 and a first light emitting part EP1 electrically connected to the first driving part DP1, the second sub-pixel may include a second driving part DP2 and a second light emitting part EP2 electrically connected to the second driving part DP2, and the third sub-pixel may include a third driving part DP3 and a third light emitting part EP3 electrically connected to the third driving part DP3.

The light emitting part EP may include a first electrode 151, an organic layer 152, and a second electrode 153, which will be described later, and may refer to a light emitting region in a region where the first electrode 151 is exposed by a bank 154. For example, the first light emitting part EP1 may refer to a region emitting red light, the second light emitting part EP2 may refer to a region emitting green light, and the third light emitting part EP3 may refer to a region emitting blue light.

The driving part DP is a concept including a driving transistor and a switching transistor, and may refer to a region for applying a voltage to the light emitting part EP.

The pixel PX disposed in the display area DA may include a first pixel further including an auxiliary pixel in addition to the first sub-pixel, the second sub-pixel, and the third sub-pixel, and a second pixel including only the first sub-pixel, the second sub-pixel, and the third sub-pixel.

A region where only the first pixel is disposed in the display area DA may be referred to as the auxiliary pixel area SDA. According to an example, the auxiliary pixel area SDA may include a first auxiliary pixel area SDA1 and a second auxiliary pixel area SDA2, but is not limited thereto.

The display panel may further include the auxiliary pixel, and a plurality of auxiliary pixels may be provided. The auxiliary pixel may include an auxiliary driving part SDP and an auxiliary light emitting part SEP electrically connected to the auxiliary driving part SDP.

The auxiliary driving part SDP of the auxiliary pixel may be disposed in the display area DA. Specifically, the auxiliary driving part SDP may be disposed in the auxiliary pixel area SDA of the display area DA. The auxiliary driving part SDP of the auxiliary pixel may be structurally the same as the driving part DP of the sub-pixels described above. The auxiliary driving part SDP may include a driving transistor 130 and a switching transistor like the driving part DP, and may be electrically connected to the auxiliary light emitting part SEP to apply a voltage to the auxiliary light emitting part SEP.

The auxiliary light emitting part SEP of the auxiliary pixel may be disposed in the non-display area NDA. Specifically, the auxiliary light emitting part SEP may be disposed to overlap the gate driver GIP disposed in the non-display area NDA. The auxiliary light emitting part SEP of the auxiliary pixel may be the same as the light emitting part EP of the sub-pixels described above. For example, the auxiliary light emitting part SEP may be structurally the same as the first light emitting part EP1, the second light emitting part EP2, or the third light emitting part EP3.

In FIG. 2, the driving part DP disposed in the display area DA and the auxiliary driving part SDP disposed in the auxiliary pixel areas (SDA1, SDA2) are not shown, and only the light emitting part EP of the sub-pixels and the auxiliary light emitting part SEP of the auxiliary pixel are shown.

The light emitting parts EP of the sub-pixels may be disposed in the display area DA as shown in FIG. 2. Specifically, the light emitting parts EP of the sub-pixels may be disposed in the display area DA including the first auxiliary pixel area SDA1 and the second auxiliary pixel area SDA2.

The light emitting parts EP of the sub-pixels may be arranged in a matrix manner along the first direction DR1 and the second direction DR2, but examples of the present disclosure are not limited thereto, and they may also be arranged in a stripe manner or a Pentile manner.

The auxiliary light emitting parts SEP of the auxiliary pixel may be disposed in the first non-display area NDA1. For example, the auxiliary light emitting parts SEP of the auxiliary pixel may be disposed in the first non-display area NDA1 to overlap the gate driver GIP. As a specific example, the auxiliary light emitting part SEP may overlap at least one of the first scan portion SC1, the second scan portion SC2, and the third scan portion SC3.

The auxiliary light emitting parts SEP of the auxiliary pixel may be disposed in the second non-display area NDA2. For example, the auxiliary light emitting parts SEP of the auxiliary pixel may be disposed in the second non-display area NDA2 to overlap the gate driver GIP. As a specific example, the auxiliary light emitting part SEP may overlap at least one of the first output portion EM1 and the second output portion EM2.

The auxiliary light emitting parts SEP of the auxiliary pixel may be arranged in a matrix manner along the first direction DR1 and the second direction DR2, but examples of the present disclosure are not limited thereto, and they may also be arranged in a stripe manner or a Pentile manner.

Hereinafter, it is described that the light emitting parts (EP, EP1, EP2, EP3) and the auxiliary light emitting parts (SEP, SEP1, SEP2, SEP3) are arranged in a stripe manner, but the following description is configured to be identically applied not only to the stripe manner but also to a matrix manner, a Pentile manner, and the like.

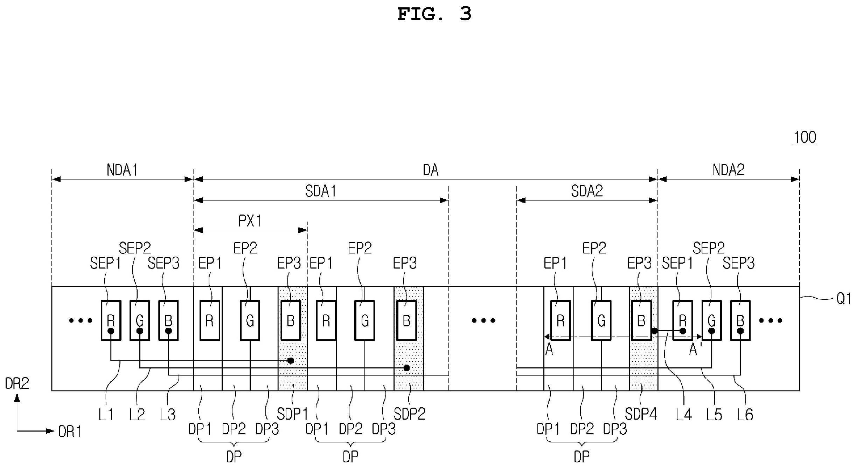

FIG. 3 is a view illustrating an enlarged view of a region Q1 of FIG. 1.

An auxiliary driving part SDP of an auxiliary pixel disposed in a display area DA may be electrically connected to an auxiliary light emitting part SEP disposed in a non-display area NDA.

According to an example, the auxiliary driving part SDP of the auxiliary pixel disposed in auxiliary pixel areas (SDA1, SDA2) may be electrically connected to the auxiliary light emitting part SEP disposed in a first non-display area NDA1 or the auxiliary light emitting part SEP disposed in a second non-display area NDA2 through a connection line L.

For example, a plurality of auxiliary light emitting parts SEP may be disposed in the first non-display area NDA1, and among the plurality of auxiliary light emitting parts SEP, a first auxiliary light emitting part SEP1 may be electrically connected to a first auxiliary driving part SDP1 disposed in a first auxiliary pixel area SDA1 through a first connection line L1, a second auxiliary light emitting part SEP2 may be electrically connected to a second auxiliary driving part SDP2 disposed in the first auxiliary pixel area SDA1 through a second connection line L2, and a third auxiliary light emitting part SEP3 may be electrically connected to a third auxiliary driving part (not shown) disposed in the first auxiliary pixel area SDA1 through a third connection line L3, but is not limited thereto.

At this time, the connection line L may pass through a driving part DP and/or the auxiliary driving part SDP. For example, the first connection line L1 may pass through a first driving part DP1, a second driving part DP2, and a third driving part DP3, the second connection line L2 may pass through the first driving part DP1, the second driving part DP2, the third driving part DP3, and the first auxiliary driving part SDP1, and the third connection line L3 may pass through the first driving part DP1, the second driving part DP2, the third driving part DP3, the first auxiliary driving part SDP1, and the second auxiliary driving part SDP2, but the driving part DP and/or the auxiliary driving part SDP through which the connection line L passes is not limited to the above-described examples.

Lengths of the connection lines L may be different. For example, there may be a plurality of connection lines L, which may include at least a first connection line L1 and a second connection line L2, and a length of the first connection line L1 and a length of the second connection line L2 may be different. As a specific example, the length of the second connection line L2 may be longer than the length of the first connection line L1, but is not limited thereto, and the length of the first connection line L1 may be longer than the length of the second connection line L2.

In addition, a plurality of auxiliary light emitting parts SEP may be disposed in the second non-display area NDA2, and among the plurality of auxiliary light emitting parts SEP, a first auxiliary light emitting part SEP1 may be electrically connected to a first auxiliary driving part SDP4 disposed in a second auxiliary pixel area SDA2 through a fourth connection line L4, a second auxiliary light emitting part SEP2 may be electrically connected to a second auxiliary driving part (not shown) disposed in the second auxiliary pixel area SDA2 through a fifth connection line L5, and a third auxiliary light emitting part SEP3 may be electrically connected to a third auxiliary driving part (not shown) disposed in the second auxiliary pixel area SDA2 through a sixth connection line L6.

Each of driving parts DP of sub-pixels disposed in the display area DA may be respectively electrically connected to a light emitting part EP of the sub-pixels disposed in the display area DA. For example, in a first sub-pixel, a first driving part DP1 and a first light emitting part EP1 disposed in the display area DA may be electrically connected, in a second sub-pixel, a second driving part DP2 and a second light emitting part EP2 disposed in the display area DA may be electrically connected, and in a third sub-pixel, a third driving part DP3 and a third light emitting part EP3 disposed in the display area DA may be electrically connected. Although not shown in FIG. 3, each of the driving part DP and the light emitting part EP of the sub-pixels disposed in the display area DA may be electrically connected through the connection line L.

A pixel PX of a display panel 100 may include a first pixel and a second pixel, which will be described later, and the first pixel and the second pixel may be provided in plurality. A first pixel PX1 may include the first sub-pixel, the second sub-pixel, the third sub-pixel, and the auxiliary driving part SDP of the auxiliary pixel, and light emitting parts (EP1, EP2, EP3) of each of the sub-pixels may be disposed to overlap the driving parts (DP1, DP2, DP3) of the sub-pixels so as to be uniformly arranged. For example, as shown in FIG. 3, a second light emitting part EP2 of the second sub-pixel may overlap at least a partial area of a third driving part DP3 of a third sub-pixel, and a third light emitting part EP3 of the third sub-pixel may overlap at least a partial area of the auxiliary driving part (SDP, SDP1, SDP2, SDP4), but is not limited thereto.

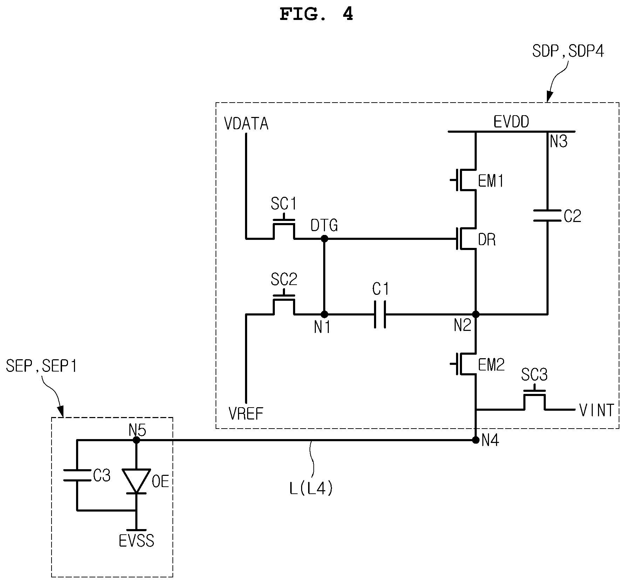

FIG. 4 is a view illustrating a circuit constituting a driving part and a light emitting part of an auxiliary pixel.

Referring to FIG. 4, the auxiliary driving part SDP of the auxiliary pixel may include a driving element DR, a first capacitor C1 electrically connected between a first node N1 and a second node N2, a second capacitor C2 electrically connected between the second node N2 and a third node N3, a plurality of scan portions (SC1, SC2, SC3), and a plurality of output portions (EM1, EM2). At this time, the driving element DR, the plurality of scan portions (SC1, SC2, SC3), and the plurality of output portions (EM1, EM2) may be implemented as a thin film transistor (TFT), but is not limited thereto.

The auxiliary driving part SDP may include a compensation circuit for sensing a threshold voltage Vth of the driving element DR and compensating a gate voltage of the driving element DR by the threshold voltage Vth of the driving element DR, and may supply a current to a light emitting element OE included in the auxiliary light emitting part SEP of the auxiliary pixel.

According to an example of the present disclosure, a source follower pixel structure of 6 transistors and 2 capacitors (6T2C) using NMOS as the compensation circuit is used, but is not limited thereto. The compensation circuit may be in various forms such as 3T1C, 4T2C, 5T2C, 6T1C, 7T1C, 7T2C, and the like.

The auxiliary light emitting part SEP of the auxiliary pixel may include the light emitting element OE and a third capacitor C3. The auxiliary light emitting part SEP may be electrically connected to the auxiliary driving part SDP through the connection line L, and a current may be supplied to the light emitting element OE. For example, for an auxiliary driving part SDP4 and the first auxiliary light emitting part SEP1 of the auxiliary pixel, a fourth node N4 of the auxiliary driving part SDP4 and a fifth node N5 of the first auxiliary light emitting part SEP1 may be electrically connected through a fourth connection line L4, and a current may be supplied to the light emitting element OE included in the first auxiliary light emitting part SEP1.

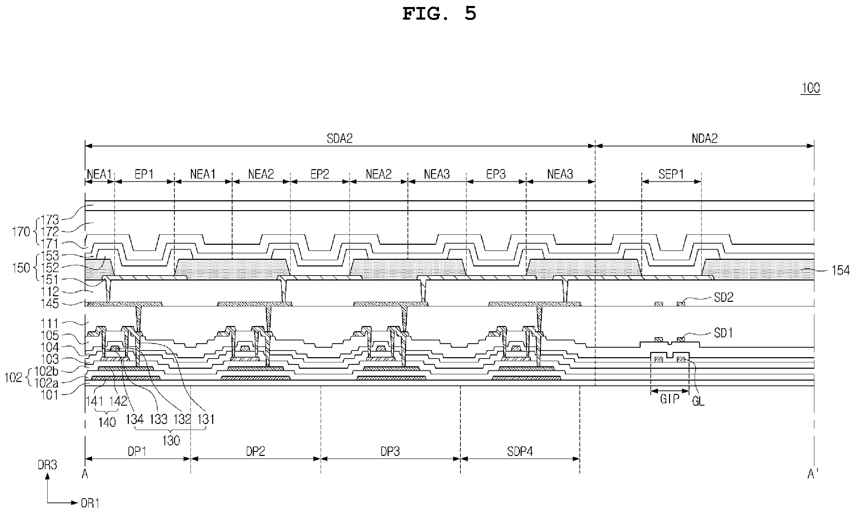

FIG. 5 is a cross-sectional view illustrating a cross-section taken along line A-A' of FIG. 3.

Referring to FIG. 5, the first sub-pixel, the second sub-pixel, the third sub-pixel, and the auxiliary driving part SDP4 of the auxiliary pixel may be disposed in the second auxiliary pixel area SDA2. For example, the first light emitting part EP1 and the first driving part DP1 of the first sub-pixel, the second light emitting part EP2 and the second driving part DP2 of the second sub-pixel, the third light emitting part EP3 and the third driving part DP3 of the third sub-pixel, and the auxiliary driving part SDP4 of the auxiliary pixel may be included in the second auxiliary pixel area SDA2.

A pixel PX of the display area 100 may include a first pixel and a second pixel, and the first pixel and the second pixel may be provided in plurality. A first pixel PX1 may include the first sub-pixel, the second sub-pixel, the third sub-pixel, and the auxiliary driving part SDP of the auxiliary pixel, and the light emitting parts (EP1, EP2, EP3) of each of the sub-pixels may be disposed to overlap the driving parts (DP1, DP2, DP3) of the sub-pixels so as to be uniformly arranged. For example, as shown in FIG. 3, the second light emitting part EP2 of the second sub-pixel may overlap at least a partial area of the third driving part DP3 of the third sub-pixel, and the third light emitting part EP3 of the third sub-pixel PXc may overlap at least a partial area of the auxiliary driving part (SDP, SDP1, SDP2, SDP4), but is not limited thereto.

The auxiliary light emitting part SEP1 of the auxiliary pixel and the gate driver GIP may be disposed in the second non-display area NDA2. Meanwhile, only the driving transistor 130 is shown in each of the driving parts (DP1, DP2, DP3) of the sub-pixels, and switching transistors are not shown.

The display panel 100 may include a substrate 101, the driving transistor 130, a light emitting layer 150, and an encapsulation unit 170.

The display panel 100 may include at least one panel insulating layer between the substrate 101 and the light emitting layer 150. The at least one panel insulating layer may include at least one of a first buffer layer 102a, a second buffer layer 102b, a first insulating layer 103, a second insulating layer 104, a third insulating layer 105, a first protection layer 111, and a second protection layer 112.

The substrate 101 may include one or more plastic materials. For example, the substrate 101 may be a multi-substrate including a plurality of plastic materials such as polyimide. For example, the substrate 101 may include a first substrate portion and a second substrate portion each including a plastic material, and a third substrate portion including an inorganic insulating material between the first substrate portion and the second substrate portion, but examples of the present disclosure are not limited thereto. The substrate 101 may be a flexible substrate.

A storage electrode 140 may be disposed on the substrate 101. The storage electrode 140 may include a first storage electrode 141 and a second storage electrode 142.

The first buffer layer 102a and the second buffer layer 102b may be disposed on the substrate 101. The first buffer layer 102a and the second buffer layer 102b may minimize or delay the diffusion of moisture or oxygen penetrating into the substrate 101. The first buffer layer 102a and the second buffer layer 102b may be formed by alternately stacking silicon nitride (SiNx) and silicon oxide (SiOx) at least once, but examples of the present disclosure are not limited thereto.

The first buffer layer 102a may be disposed on the first storage electrode 141, and the second storage electrode 142 may be disposed on the first buffer layer 102a. The second buffer layer 102b may be disposed on the second storage electrode 142.

The first insulating layer 103 may be disposed on the second buffer layer 102b. The first insulating layer 103 may be made of the same material as the buffer layers (102a, 102b), but examples of the present disclosure are not limited thereto. For example, the first insulating layer 103 may be made of an inorganic insulating material such as silicon nitride (SiNx) or silicon oxide (SiOx), but examples of the present disclosure are not limited thereto.

The driving transistor 130 may be disposed on the second buffer layer 102b. The driving transistor 130 may include a source electrode 131, a gate electrode 132, a semiconductor layer 133, and a drain electrode 134. The semiconductor layer 133 disposed on the second buffer layer 102b may include a source region, a drain region, and a channel region between the source region and the drain region.

The semiconductor layer 133 may include a metal oxide semiconductor such as IGZO (Indium-Gallium-Zinc Oxide), or a silicon-based semiconductor material such as amorphous silicon or polycrystalline silicon, but examples of the present disclosure are not limited thereto.

The first insulating layer 103 may be disposed on the semiconductor layer 133. The first insulating layer 103 may be made of the same material as the buffer layers (102a, 102b), but examples of the present disclosure are not limited thereto. For example, the first insulating layer 103 may be made of an inorganic insulating material such as silicon nitride (SiNx) or silicon oxide (SiOx), but examples of the present disclosure are not limited thereto.

The gate electrode 132 may be disposed on the first insulating layer 103. The gate electrode 132 may be formed of a single layer or a multilayer including molybdenum (Mo), copper (Cu), titanium (Ti), aluminum (Al), chromium (Cr), gold (Au), nickel (Ni), neodymium (Nd), or a compound thereof, but examples of the present disclosure are not limited thereto.

The second insulating layer 104 may be disposed on the gate electrode 132, and the third insulating layer 105 may be disposed on the second insulating layer 104. The second insulating layer 104 and the third insulating layer 105 may be the same material as the first insulating layer 103, but examples of the present disclosure are not limited thereto.

The source electrode 131 and the drain electrode 134 may be disposed on the third insulating layer 105. The source electrode 131 and the drain electrode 134 may be made of the same material and may be disposed on the same layer, but examples of the present disclosure are not limited thereto. For example, the source electrode 131 and the drain electrode 134 may be a single layer or a multilayer made of any one of molybdenum (Mo), aluminum (Al), chromium (Cr), gold (Au), titanium (Ti), nickel (Ni), neodymium (Nd), and copper (Cu), or an alloy thereof, but examples of the present disclosure are not limited thereto. For example, the source electrode 131 may be electrically connected to the second storage electrode 142. The source electrode 131 may be electrically connected to the second storage electrode 142 by penetrating the first insulating layer 103, the second insulating layer 104, and the third insulating layer 105.

The first protection layer 111 may be disposed on the source electrode 131 and the drain electrode 134.

The first protection layer 111 is configured to planarize an upper portion of the driving transistor 130 and protect the driving transistor 130. The first protection layer 111 may be made of an organic material. For example, the first protection layer 111 may be formed of an organic material including an acrylic resin, an epoxy resin, a phenolic resin, a polyamide resin, or a polyimide resin, but examples of the present disclosure are not limited thereto.

The second protection layer 112 may be disposed on the first protection layer 111. The second protection layer 112 may be formed of the same material as the first protection layer 111, but examples of the present disclosure are not limited thereto.

In some examples, a third protection layer may be further disposed on a top surface of the second protection layer 113, but examples of the present disclosure are not limited thereto.

A connection electrode 145 may be disposed between the first protection layer 111 and the second protection layer 112.

The connection electrode 145 may electrically connect the driving transistor 130 and the light emitting layer 150. The connection electrode 145 may be made of the same material as the source electrode 131 and the drain electrode 134, but examples of the present disclosure are not limited thereto.

The connection electrode 145 may be a single layer or a multilayer made of any one of molybdenum (Mo), aluminum (Al), chromium (Cr), gold (Au), titanium (Ti), nickel

(Ni), neodymium (Nd), and copper (Cu), or an alloy thereof, but examples of the present disclosure are not limited thereto.

The light emitting layer 150 may be disposed on the second protection layer 112. The light emitting layer 150 may include a first electrode 151, an organic layer 152, and a second electrode 153. The first electrode 151 is configured to function as an anode, and the second electrode 153 may function as a cathode.

The first electrode 151 may be disposed on the second protection layer 112. The first electrode 151 may be electrically connected to the driving transistor 130 through a contact hole formed in the second protection layer 112. The first electrode 151 may be a reflective electrode for reflecting light, but examples of the present disclosure are not limited thereto. The first electrode 151 may include a metal material having high reflectivity such as a stack structure (Ti/Al/Ti) of aluminum (Al) and titanium (Ti), a stack structure (ITO/Al/ITO) of aluminum (Al) and ITO, or an APC alloy, and may be formed of a single layer or a multilayer, but examples of the present disclosure are not limited thereto.

The organic layer 152 may be disposed on the first electrode 151. The organic layer 152 may include one or more light emitting structures (or light emitting elements or devices) stacked in an order or a reverse order of a hole transport layer and an electron transport layer on the first electrode 151. For example, the hole transport layer may include a hole transport layer, a hole injection layer, an electron blocking layer, or a P-type charge generation layer, but examples of the present disclosure are not limited thereto. For example, the electron transport layer may include an electron transport layer, an electron injection layer, a hole blocking layer, or an N-type charge generation layer, but examples of the present disclosure are not limited thereto. The organic layer 152 may be an organic light emitting layer, an inorganic light emitting layer, a quantum dot light emitting layer, a micro light emitting diode, or a micro-mini light emitting diode, but examples of the present disclosure are not limited thereto. For example, the organic layer 152 of the display panel 100 according to an example of the present disclosure may include an organic light emitting layer. The organic layer 152 may include a red light emitting layer, a green light emitting layer, and a blue light emitting layer. The organic layer 152 may further include a white light emitting layer, but examples of the present disclosure are not limited thereto.

The second electrode 153 may be disposed on the organic layer 152. The second electrode 153 may be a transparent electrode for transmitting light, but examples of the present disclosure are not limited thereto. For example, the second electrode 153 may include a transparent conductive material such as ITO (Indium Tin Oxide) or IZO (Indium Zinc Oxide) or a metal through which visible light is transmitted, but examples of the present disclosure are not limited thereto.

A bank 154 may be disposed to expose the first electrode 151. The bank 154 is configured to define openings (or light emitting parts (EP1, EP2, EP3)) of sub-pixels and be disposed to cover an edge portion (or a border portion or a periphery) of the first electrode 151. That is, a first sub-pixel includes a first light emitting part EP1 and a first non-light emitting region NEA1 around the first light emitting part EP1, a second sub-pixel includes a second light emitting part EP2 and a second non-light emitting region NEA2 around the second light emitting part EP2, and a third sub-pixel includes a third light emitting part EP3 and a third non-light emitting region NEA3 around the third light emitting part EP3. That is, each non-light emitting region (NEA1, NEA2, NEA3) may correspond to a boundary between adjacent sub-pixels.

The bank 154 may include a black-based material. For example, the bank 154 may be formed of a material including a black pigment or an organic material such as a benzocyclobutene resin, a polyimide resin, an acrylic resin, or a photosensitive polymer, but examples of the present disclosure are not limited thereto. When the bank 154 is formed of a material including a black pigment or a black dye, it may be a black bank. When the bank 154 is formed of a material including a black pigment or a black dye, light from the outside may be blocked or light reflected from the outside may be blocked, so that the brightness of the display device may be further improved.

The organic layer 152 may be disposed on the first electrode 151 and the bank 154. The second electrode 153 may be disposed on the organic layer 152.

An encapsulation unit 170 may be disposed on the second electrode 153. The encapsulation unit 170 may include one or more insulating layers. For example, the encapsulation unit 170 may include a first encapsulation layer 171, a second encapsulation layer 172 on the first encapsulation layer 171, and a third encapsulation layer 173 on the second encapsulation layer 172. The encapsulation unit 170 may include one or more inorganic insulating material layers and one or more organic material layers. For example, the first encapsulation layer 171 and the third encapsulation layer 173 may include an inorganic insulating material, and the second encapsulation layer 172 may include an organic material, but examples of the present disclosure are not limited thereto.

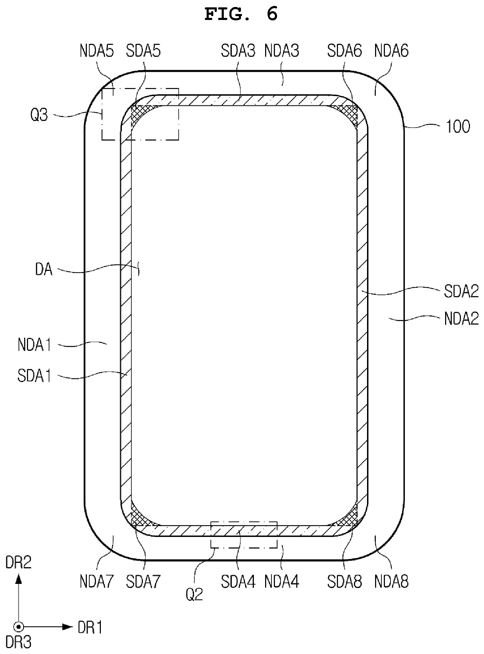

FIG. 6 is a plan view of a display device according to an example.

Referring to FIG. 6, a non-display area (NDA) surrounding a display area (DA) may include a first non-display area (NDA1), a second non-display area (NDA2), a third non-display area (NDA3), a fourth non-display area (NDA4), a fifth non-display area (NDA5), a sixth non-display area (NDA6), a seventh non-display area (NDA7), and an eighth non-display area (NDA8).

The first non-display area (NDA1) and the second non-display area (NDA2) may refer to the non-display area (NDA) where a gate driver (GIP) is disposed, as described in FIG. 1. For example, the first non-display area (NDA1) may refer to the non-display area (NDA) located on a left side when a display panel 100 is viewed from a direction opposite to a third direction (DR3), and the second non-display area (NDA2) may refer to the non-display area (NDA) located on a right side when the display panel 100 is viewed from the direction opposite to the third direction (DR3).

The third non-display area (NDA3) and the fourth non-display area (NDA4) may refer to some areas among the non-display areas (NDA) where the gate driver (GIP) is not disposed. For example, the third non-display area (NDA3) may refer to the non-display area (NDA) located at an upper side when the display panel 100 is viewed from the direction opposite to the third direction (DR3), and the fourth non-display area (NDA4) may refer to the non-display area (NDA) located at a lower side when the display panel 100 is viewed from the direction opposite to the third direction (DR3).

The fifth non-display area (NDA5), the sixth non-display area (NDA6), the seventh non-display area (NDA7), and the eighth non-display area (NDA8) may refer to areas located diagonally among the non-display areas (NDA). For example, the fifth non-display area (NDA5) may refer to an area located between the first non-display area (NDA1) and the third non-display area (NDA3) among the non-display areas (NDA). The sixth non-display area (NDA6) may refer to an area located between the second non-display area (NDA2) and the third non-display area (NDA3) among the non-display areas (NDA). The seventh non-display area (NDA7) may refer to an area located between the first non-display area (NDA1) and the fourth non-display area (NDA4) among the non-display areas (NDA). The eighth non-display area (NDA8) may refer to an area located between the second non-display area (NDA2) and the fourth non-display area (NDA4) among the non-display areas (NDA).

The display area (DA) may include an auxiliary pixel area (SDA). The auxiliary pixel area (SDA) may include at least one of a first auxiliary pixel area (SDA1), a second auxiliary pixel area (SDA2), a third auxiliary pixel area (SDA3), a fourth auxiliary pixel area (SDA4), a fifth auxiliary pixel area (SDA5), a sixth auxiliary pixel area (SDA6), a seventh auxiliary pixel area (SDA7), or an eighth auxiliary pixel area (SDA8).

According to an example, an auxiliary pixel may be disposed only in a region where a reduction of the non-display area (NDA) is required, in order to have an effect of reducing pixel density of the display area (DA). For example, the auxiliary pixel area (SDA) may include the first auxiliary pixel area (SDA1) and the second auxiliary pixel area (SDA2), include the third auxiliary pixel area (SDA3) and the fourth auxiliary pixel area (SDA4), or include all of the first to eighth auxiliary pixel areas (SDA1 to SDA8), but the auxiliary pixel area (SDA) is not limited only to the described examples.

The first auxiliary pixel area (SDA1) and the second auxiliary pixel area (SDA2) may refer to some areas adjacent to the gate driver (GIP) disposed in the non-display area (NDA) among the display area (DA). Alternatively, the first auxiliary pixel area (SDA1) may refer to a partial area located at a left periphery of the display area (DA) when the display area (DA) is viewed from the direction opposite to the third direction (DR3), and the second auxiliary pixel area (SDA2) may refer to a partial area located at a right periphery of the display area (DA) when the display area (DA) is viewed from the direction opposite to the third direction (DR3). Alternatively, the first auxiliary pixel area (SDA1) may refer to an area adjacent to the first non-display area (NDA1) among the display area (DA), and the second auxiliary pixel area (SDA2) may refer to an area adjacent to the second non-display area (NDA2) among the display area (DA).

The third auxiliary pixel area (SDA3) and the fourth auxiliary pixel area (SDA4) may refer to some areas adjacent to the non-display area (NDA) where the gate driver (GIP) is not disposed among the display area (DA). Alternatively, the third auxiliary pixel area (SDA3) may refer to a partial area located at an upper periphery of the display area (DA) when the display area (DA) is viewed from the direction opposite to the third direction (DR3), and the fourth auxiliary pixel area (SDA4) may refer to a partial area located at a lower periphery of the display area (DA) when the display area (DA) is viewed from the direction opposite to the third direction (DR3). Alternatively, the third auxiliary pixel area may refer to an area adjacent to the third non-display area (NDA3) among the display area (DA), and the fourth auxiliary pixel area may refer to an area adjacent to the fourth non-display area (NDA4) among the display area (DA).

The fifth auxiliary pixel area (SDA5), the sixth auxiliary pixel area (SDA6), the seventh auxiliary pixel area (SDA7), and the eighth auxiliary pixel area (SDA8) may refer to some areas located at a diagonal periphery among the display area (DA). For example, the fifth auxiliary pixel area (SDA5) may refer to a partial area located at a diagonal periphery between the first auxiliary pixel area (SDA1) and the third auxiliary pixel area (SDA3) when the display area (DA) is viewed from the direction opposite to the third direction (DR3). The sixth auxiliary pixel area (SDA6) may refer to a partial area located at a diagonal periphery between the second auxiliary pixel area (SDA2) and the third auxiliary pixel area (SDA3) when the display area (DA) is viewed from the direction opposite to the third direction (DR3). The seventh auxiliary pixel area (SDA7) may refer to a partial area located at a diagonal periphery between the first auxiliary pixel area (SDA1) and the fourth auxiliary pixel area (SDA4) when the display area (DA) is viewed from the direction opposite to the third direction (DR3). The eighth auxiliary pixel area (SDA8) may refer to a partial area located at a diagonal periphery between the second auxiliary pixel area (SDA2) and the fourth auxiliary pixel area (SDA4) when the display area (DA) is viewed from the direction opposite to the third direction (DR3).

Alternatively, the fifth auxiliary pixel area (SDA5) may refer to an area adjacent to the fifth non-display area (NDA5) among the display area (DA), the sixth auxiliary pixel area (SDA6) may refer to an area adjacent to the sixth non-display area (NDA6) among the display area (DA), the seventh auxiliary pixel area (SDA7) may refer to an area adjacent to the seventh non-display area (NDA7) among the display area (DA), and the eighth auxiliary pixel area (SDA8) may refer to an area adjacent to the eighth non-display area (NDA8) among the display area (DA).

Meanwhile, although FIG. 6 illustrates the auxiliary pixel area (SDA) where the auxiliary pixel is disposed as being a partial area located at the periphery of the display area (DA), the auxiliary pixel area (SDA) may also correspond to an entire area including the periphery and the center of the display area (DA). That is, the auxiliary pixel may also be disposed throughout the display area (DA). In this case, an auxiliary driving part (SDP) of the auxiliary pixel located at the periphery of the display area (DA) may be electrically connected to an auxiliary light emitting part (SEP) located in the non-display area (NDA) for a reduction of the non-display area (NDA), and the auxiliary driving part (SDP) of the auxiliary pixel located at the center of the display area (DA) may not be electrically connected to the auxiliary light emitting part (SEP). Through this, all pixels (PX) disposed in the display area (DA) may have the same size, thereby reducing a difference in image quality caused by a difference in pixel density.

In addition, the auxiliary pixel may be disposed in the display area (DA) such that a density at which the auxiliary driving part (SDP) is disposed decreases from the periphery to the center of the display area (DA). Through this, it is possible to prevent the difference in image quality between a region including the auxiliary pixel and a region not including it from increasing. A distance between the auxiliary light emitting part (SEP) and the auxiliary driving part (SDP) may be farther as it is closer to the periphery of the display area (DA), and the distance between the auxiliary light emitting part (SEP) and the auxiliary driving part (SDP) may be closer as it is closer to the center of the display area (DA).

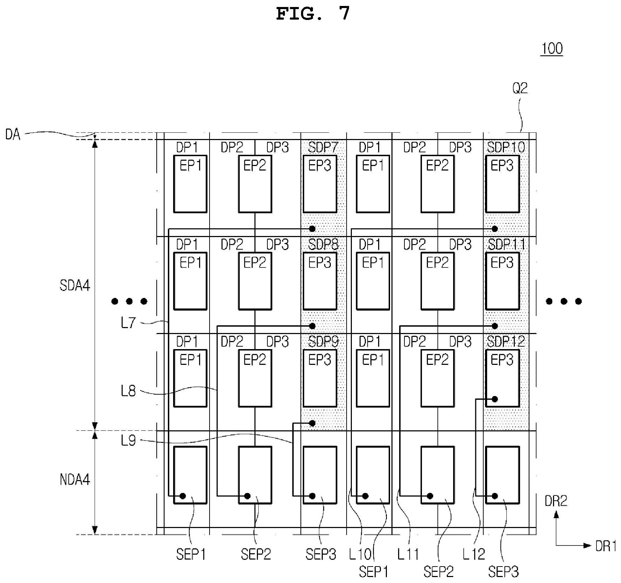

FIG. 7 is a view illustrating an enlarged view of a region Q2 of FIG. 6.

The auxiliary driving part (SDP) of the auxiliary pixel disposed in the display area (DA) may be electrically connected to the auxiliary light emitting part (SEP) disposed in the non-display area (NDA).

According to an example, the auxiliary driving part (SDP) of the auxiliary pixel disposed in auxiliary pixel areas (SDA3, SDA4) may be electrically connected to the auxiliary light emitting part (SEP) disposed in non-display areas (NDA3, NDA4) through a connection line (L).

For example, referring to FIG. 7, a plurality of auxiliary light emitting parts (SEP) may be disposed in the fourth non-display area (NDA4), and among the plurality of auxiliary light emitting parts (SEP), a first auxiliary light emitting part (SEP1) may be electrically connected to a seventh auxiliary driving part (SDP7) disposed in a fourth auxiliary pixel area (SDA4) through a seventh connection line (L7), a second auxiliary light emitting part (SEP2) may be electrically connected to an eighth auxiliary driving part (SDP8) disposed in the fourth auxiliary pixel area (SDA4) through an eighth connection line (L8), and a third auxiliary light emitting part (SEP3) may be electrically connected to a ninth auxiliary driving part (SDP9) disposed in the fourth auxiliary pixel area (SDA4) through a ninth connection line (L9), but is not limited thereto, and a structure in which the plurality of auxiliary light emitting parts (SEP) disposed in the fourth non-display area (NDA4) are respectively electrically connected to the plurality of auxiliary driving parts (SDP) of the fourth auxiliary pixel area (SDA4) through the connection lines (L) may be repeated. For example, as shown in FIG. 7, the first auxiliary light emitting part (SEP1) may be electrically connected to a tenth auxiliary driving part (SDP10) disposed in the fourth auxiliary pixel area (SDA4) through a tenth connection line (L10), the second auxiliary light emitting part (SEP2) may be electrically connected to an eleventh auxiliary driving part (SDP11) disposed in the fourth auxiliary pixel area (SDA4) through an eleventh connection line (L11), and the third auxiliary light emitting part (SEP3) may be electrically connected to a twelfth auxiliary driving part (SDP12) disposed in the fourth auxiliary pixel area (SDA4) through a twelfth connection line (L12).

The connection line (L) may pass through a driving part (DP) and/or the auxiliary driving part (SDP) disposed in the auxiliary pixel area (SDA). For example, the seventh to twelfth connection lines (L7, L8, L9, L10, L11, L12) may pass through at least one driving part (DP) among a first driving part (DP1), a second driving part (DP2), and a third driving part (DP3).

There may be a plurality of connection lines (L), and lengths of the plurality of connection lines (L) may be different. As shown in FIG. 7, lengths of the seventh to ninth connection lines (L7, L8, L9) may be different, respectively, and a length of the seventh connection line (L7) may be longer than a length of the eighth connection line (L8), and the length of the eighth connection line (L8) may be longer than a length of the ninth connection line (L9). In addition, lengths of the tenth to twelfth connection lines (L10, L11, L12) may also be different, respectively, and a length of the tenth connection line (L10) may be longer than a length of the eleventh connection line (L11), and the length of the eleventh connection line (L11) may be longer than a length of the twelfth connection line (L12).

In addition, although not shown in FIG. 7, each driving part (DP) and light emitting part (EP) of sub-pixels disposed in the fourth auxiliary pixel area (SDA4) may be electrically connected through the connection line (L).

Although only the fourth auxiliary pixel area (SDA4) and the fourth non-display area (NDA4) have been described above, the above description is configured to be identically applied to the third auxiliary pixel area (SDA3) and the third non-display area (NDA3), and thus redundant descriptions are omitted.

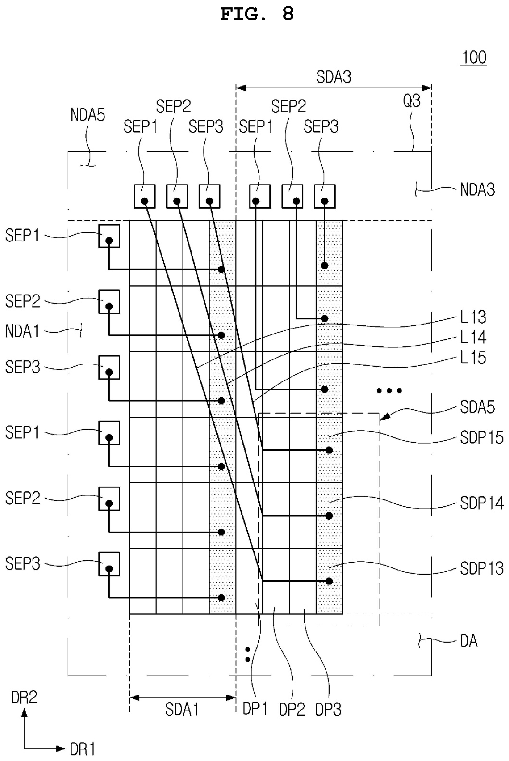

FIG. 8 is a view illustrating an enlarged view of a region Q3 of FIG. 6.

The auxiliary driving part (SDP) of the auxiliary pixel disposed in the display area (DA) may be electrically connected to the auxiliary light emitting part (SEP) disposed in the non-display area (NDA).

According to an example, the auxiliary driving part (SDP) of the auxiliary pixel disposed in auxiliary pixel areas (SDA5, SDA6, SDA7, SDA8) may be electrically connected to the auxiliary light emitting part (SEP) disposed in non-display areas (NDA5, NDA6, NDA7, NDA8) through a connection line (L).

For example, referring to FIG. 8, a plurality of auxiliary light emitting parts (SEP) may be disposed in the fifth non-display area (NDA5), and among the plurality of auxiliary light emitting parts (SEP), a first auxiliary light emitting part (SEP1) may be electrically connected to a thirteenth auxiliary driving part (SDP13) disposed in a fifth auxiliary pixel area (SDA5) through a thirteenth connection line (L13), a second auxiliary light emitting part (SEP2) may be electrically connected to a fourteenth auxiliary driving part (SDP14) disposed in the fifth auxiliary pixel area (SDA5) through a fourteenth connection line (L14), and a third auxiliary light emitting part (SEP3) may be electrically connected to a fifteenth auxiliary driving part (SDP15) disposed in the fifth auxiliary pixel area (SDA5) through a fifteenth connection line (L15), but is not limited thereto, and a structure in which the plurality of auxiliary light emitting parts (SEP) disposed in the fifth non-display area (NDA5) are respectively electrically connected to the plurality of auxiliary driving parts (SDP) of the fifth auxiliary pixel area (SDA5) through the connection lines (L) may be repeated.

The connection line (L) may pass through the driving part (DP) and/or the auxiliary driving part (SDP) disposed in the auxiliary pixel area (SDA). For example, the thirteenth to fifteenth connection lines (L13, L14, L15) may pass through at least one or more of the first driving part (DP1), the second driving part (DP2), the third driving part (DP3), and/or the auxiliary driving part (SDP).

There may be a plurality of connection lines (L), and lengths of the plurality of connection lines (L) may be different. As shown in FIG. 8, lengths of the thirteenth to fifteenth connection lines (L13, L14, L15) may be different, respectively. A length of the thirteenth connection line (L13) may be longer than a length of the fourteenth connection line (L14), and the length of the fourteenth connection line (L14) may be longer than a length of the fifteenth connection line (L15).

The connection line (L) for electrically connecting the auxiliary light emitting part (SEP) and the auxiliary driving part (SDP) of an auxiliary pixel in a diagonal area such as the fifth non-display area (NDA5) and the fifth auxiliary pixel area (SDA5) may be disposed on a separate layer from the connection line (L) for electrically connecting the auxiliary light emitting part (SEP) and the auxiliary driving part (SDP) of the auxiliary pixel located in left/right areas or upper/lower areas of the display panel 100.

For example, the connection line (L) for electrically connecting the auxiliary light emitting part (SEP) and the auxiliary driving part (SDP) of the auxiliary pixel located in the left/right areas or the upper/lower areas of the display panel 100 may be disposed as a connection electrode 145 between a first protection layer 111 and a second protection layer 112, and the connection line (L) for electrically connecting the auxiliary light emitting part (SEP) and the auxiliary driving part (SDP) of the auxiliary pixel in the diagonal area may be disposed as a connection electrode between the second protection layer 112 and a third protection layer which may be further disposed on the second protection layer 112, but is not limited thereto, and the connection lines (L) may also be disposed on the same layer.

In addition, although not shown in FIG. 8, each driving part (DP) and light emitting part (EP) of sub-pixels disposed in the fifth auxiliary pixel area (SDA5) may be electrically connected through the connection line (L).

Although only the fifth auxiliary pixel area (SDA5) and the fifth non-display area (NDA5) have been described above, the above description is configured to be identically applied to the sixth auxiliary pixel area (SDA6), the sixth non-display area (NDA6), the seventh auxiliary pixel area (SDA7), the seventh non-display area (NDA7), the eighth auxiliary pixel area (SDA8), and the eighth non-display area (NDA8), and thus redundant descriptions are omitted.

In addition, the above description regarding the first non-display area (NDA1) and the first auxiliary pixel area (SDA1), and the third non-display area (NDA3) and the third auxiliary pixel area (SDA3) is configured to be identically applied to other respective areas, and thus redundant descriptions are omitted.

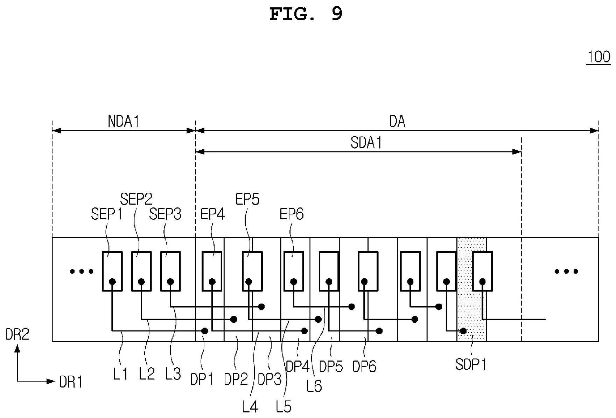

FIG. 9 is a view for explaining a position of an auxiliary pixel according to an example.

A pixel (PX) disposed in the display area (DA) may include a plurality of first pixels and a plurality of second pixels. The first pixel may refer to a pixel including a first sub-pixel, a second sub-pixel, a third sub-pixel, and the auxiliary driving part (SDP) of the auxiliary pixel, and the second pixel may refer to a pixel including only the first sub-pixel, the second sub-pixel, and the third sub-pixel.

Sizes of the first pixel and the second pixel may be the same, but sizes of the sub-pixels and the auxiliary pixel of the first pixel and sizes of the sub-pixels of the second pixel may be different. For example, lengths defined along the first direction (DR1) of each of the sub-pixels and the auxiliary driving part (SDP) of the first pixel may be smaller than lengths defined along the first direction (DR1) of each of the sub-pixels of the second pixel.

According to an example, only the first pixel may be disposed in the auxiliary pixel area (SDA) of the display area (DA). For example, the first sub-pixel, the second sub-pixel, the third sub-pixel, and the auxiliary driving part (SDP) of the auxiliary pixel may be sequentially repeated and disposed in the auxiliary pixel area (SDA).

According to an example, the first pixel may be disposed together with a plurality of second pixels in the auxiliary pixel area (SDA) of the display area (DA). For example, as shown in FIG. 9, the first sub-pixel, the second sub-pixel, and the third sub-pixel are sequentially repeated and disposed, and one auxiliary driving part (SDP1) of the auxiliary pixel may be disposed, but it is not limited thereto. When the first pixel is disposed together with the plurality of second pixels in the auxiliary pixel area (SDA), it may be easy to reduce the size of the pixel (PX).

At this time, the auxiliary light emitting part (SEP) disposed in the non-display area (NDA) may not be electrically connected to the auxiliary driving part (SDP) disposed in the auxiliary pixel area (SDA), and may be respectively electrically connected to driving parts (DP) of the sub-pixels disposed in the auxiliary pixel area (SDA).

Referring to FIG. 9, a plurality of auxiliary light emitting parts (SEP) may be disposed in the first non-display area (NDA1), and among the plurality of auxiliary light emitting parts (SEP), the first auxiliary light emitting part (SEP1) may be electrically connected to a first driving part (DP1) of a first sub-pixel disposed in the first auxiliary pixel area (SDA1) through the first connection line (L1). The second auxiliary light emitting part (SEP2) may be electrically connected to a second driving part (DP2) of a second sub-pixel disposed in the first auxiliary pixel area (SDA1) through the second connection line (L2). The third auxiliary light emitting part (SEP3) may be electrically connected to a third driving part (DP3) of a third sub-pixel disposed in the first auxiliary pixel area (SDA1) through the third connection line (L3).

At this time, a light emitting part (EP4) of the first sub-pixel disposed in the first auxiliary pixel area (SDA1) may be electrically connected to a first driving part (DP4) of another first sub-pixel through a fourth connection line (L4), a light emitting part (EP5) of the second sub-pixel may be electrically connected to a second driving part (DP5) of another second sub-pixel through a fifth connection line (L5), and a light emitting part (EP6) of the third sub-pixel may be electrically connected to a third driving part (DP6) of another third sub-pixel through a sixth connection line (L6), and hereafter redundant descriptions are omitted. Through this, by making an interval of the light emitting part wider than an interval of the sub-pixels, an effect of reducing a thickness of the non-display area (NDA) may be obtained.

Each connection line (L) electrically connecting the auxiliary light emitting part (SEP) disposed in the non-display area (NDA) and the driving part (DP) or the auxiliary driving part (SDP) disposed in the auxiliary pixel area (SDA) may have the same length.

According to an example, the auxiliary driving part (SDP) of the auxiliary pixel in the first pixel may be located at a left side, a right side, or between the sub-pixels. For example, the first sub-pixel, the second sub-pixel, the third sub-pixel, and the auxiliary driving part (SDP) of the auxiliary pixel may be sequentially disposed. Alternatively, the auxiliary driving part (SDP) of the auxiliary pixel, the first sub-pixel, the second sub-pixel, and the third sub-pixel may be disposed in this order. Alternatively, the first sub-pixel, the second sub-pixel, the auxiliary driving part (SDP) of the auxiliary pixel, and the third sub-pixel may be disposed in this order, but is not limited thereto.

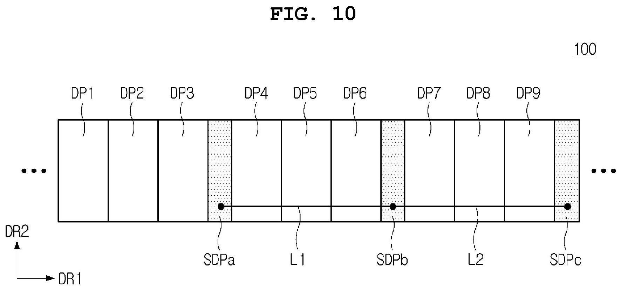

FIG. 10 is a view for explaining a position of an auxiliary pixel according to an example.

An auxiliary driving part SDP of an auxiliary pixel may be divided and disposed between sub-pixels.

According to an example, the auxiliary driving part SDP may include a first auxiliary driving part SDPa, a second auxiliary driving part SDPb, and a third auxiliary driving part SDPc.

The second auxiliary driving part SDPb may refer to a first capacitor C1 electrically connected between a first node N1 and a second node N2 in FIG. 4 described above, and the third auxiliary driving part SDPc may refer to a second capacitor C2 electrically connected between the second node N2 and a third node N3, and the first auxiliary driving part SDPa may refer to the remaining configurations except for the first capacitor C1 and the second capacitor C2, but the auxiliary driving part SDP may be divided into at least two or more according to functions, and is not limited to the above-described example.

The first auxiliary driving part SDPa may be disposed between a third driving part DP3 of a third sub-pixel and a first driving part DP4 of a first sub-pixel, the second auxiliary driving part SDPb may be disposed between a third driving part DP6 of the third sub-pixel and a first driving part DP7 of the first sub-pixel, and the third auxiliary driving part SDPc may be disposed between the third driving part DP9 of the third sub-pixel and a first driving part (not shown) of the first sub-pixel.

The first auxiliary driving part SDPa, the second auxiliary driving part SDPb, and the third auxiliary driving part SDPc may be electrically connected to each other through a connection line L. Referring to FIG. 10, the first auxiliary driving part SDPa may be electrically connected to the second auxiliary driving part SDPb through a first connection line L1, and the second auxiliary driving part SDPb may be electrically connected to the third auxiliary driving part SDPc through a second connection line L2, and although not shown in FIG. 10, the first auxiliary driving part SDPa may be electrically connected to an auxiliary light emitting part SEP of the auxiliary pixel through the connection line L.

Even when a space is narrow to additionally dispose an entire auxiliary driving part SDP, the auxiliary driving part SDP may be added by dividing the auxiliary driving part SDP according to functions and disposing it between the sub-pixels.

A display device according to examples of the present disclosure includes: a display area where a first pixel including a first sub-pixel, a second sub-pixel, a third sub-pixel, and an auxiliary driving part of an auxiliary pixel is disposed; and a non-display area which is disposed around the display area and where an auxiliary light emitting part of the auxiliary pixel is disposed, wherein the auxiliary light emitting part is electrically connected to the auxiliary driving part.

In the display device according to examples of the present disclosure, the auxiliary driving part includes a driving transistor and a switching transistor, the first sub-pixel includes a first driving part and a first light emitting part electrically connected to the first driving part, the second sub-pixel includes a second driving part and a second light emitting part electrically connected to the second driving part, the third sub-pixel includes a third driving part and a third light emitting part electrically connected to the third driving part, and the auxiliary light emitting part of the auxiliary pixel may be the same as the first light emitting part, the second light emitting part, or the third light emitting part.

In the display device according to examples of the present disclosure, the second light emitting part overlaps at least a partial region of the third driving part, and the third light emitting part overlaps at least a partial region of the auxiliary driving part.

In the display device according to examples of the present disclosure, the pixel may include a plurality of the first sub-pixels, a plurality of the second sub-pixels, and a plurality of the third sub-pixels.

In the display device according to examples of the present disclosure, the auxiliary driving part includes a first auxiliary driving part, a second auxiliary driving part, and a third auxiliary driving part, and each of the first auxiliary driving part, the second auxiliary driving part, and the third auxiliary driving part may be disposed between the first sub-pixel and the third sub-pixel.

In the display device according to examples of the present disclosure, the auxiliary driving part of the auxiliary pixel may be disposed only in a partial area of a periphery of the display area.

In the display device according to examples of the present disclosure, the auxiliary driving part of the auxiliary pixel may be disposed in an entire area including a periphery and a center of the display area.

In the display device according to examples of the present disclosure, the auxiliary driving part of the auxiliary pixel is disposed only in a partial area of a periphery of the display area, and a density at which the auxiliary driving part is disposed may decrease toward a center of the display area from the periphery.

In the display device according to examples of the present disclosure, a second pixel including only the first sub-pixel, the second sub-pixel, and the third sub-pixel may be further disposed in the display area, and a size of the first pixel and a size of the second pixel may be the same.

In the display device according to examples of the present disclosure, sizes of the first sub-pixel, the second sub-pixel, and the third sub-pixel of the first pixel may be smaller than sizes of the first sub-pixel, the second sub-pixel, and the third sub-pixel of the second pixel.

A display device according to examples of the present disclosure includes: a substrate including a display area and a non-display area around the display area; a first driving part of a first sub-pixel, a second driving part of a second sub-pixel, a third driving part of a third sub-pixel, and an auxiliary driving part of an auxiliary pixel, which are disposed in the display area; a first light emitting part of the first sub-pixel disposed on the first driving part and electrically connected to the first driving part; a second light emitting part of the second sub-pixel disposed on the second driving part and electrically connected to the second driving part; and a third light emitting part of the third sub-pixel disposed on the third driving part and electrically connected to the third driving part, wherein an auxiliary light emitting part of the auxiliary pixel is disposed in the non-display area, and the auxiliary light emitting part and the auxiliary driving part of the display area are electrically connected.

In the display device according to examples of the present disclosure, the auxiliary driving part includes a driving transistor and a switching transistor, and the auxiliary light emitting part may be the same as the first light emitting part, the second light emitting part, or the third light emitting part.

In the display device according to examples of the present disclosure, the second light emitting part overlaps at least a partial region of the third driving part, and the third light emitting part may overlap at least a partial region of the auxiliary driving part.

In the display device according to examples of the present disclosure, a first pixel including the first sub-pixel, the second sub-pixel, the third sub-pixel, and the auxiliary driving part of the auxiliary pixel is disposed in the display area, and the first pixel may include a plurality of the first sub-pixels, a plurality of the second sub-pixels, and a plurality of the third sub-pixels.

In the display device according to examples of the present disclosure, the auxiliary driving part includes a first auxiliary driving part, a second auxiliary driving part, and a third auxiliary driving part, and each of the first auxiliary driving part, the second auxiliary driving part, and the third auxiliary driving part may be respectively disposed between the first sub-pixel and the third sub-pixel.

In the display device according to examples of the present disclosure, the auxiliary driving part of the auxiliary pixel may be disposed only in a partial area of a periphery of the display area.

In the display device according to examples of the present disclosure, the auxiliary driving part of the auxiliary pixel may be disposed in an entire area including a periphery and a center of the display area.

In the display device according to examples of the present disclosure, the auxiliary driving part of the auxiliary pixel is disposed only in a partial area of a periphery of the display area, and a density at which the auxiliary driving part is disposed may decrease toward a center of the display area from the periphery.

In the display device according to examples of the present disclosure, a first pixel including the first sub-pixel, the second sub-pixel, the third sub-pixel, and the auxiliary driving part of the auxiliary pixel is disposed in the display area, a second pixel including only the first sub-pixel, the second sub-pixel, and the third sub-pixel is further disposed in the display area, and a size of the first pixel and a size of the second pixel may be the same.

In the display device according to examples of the present disclosure, sizes of the first sub-pixel, the second sub-pixel, and the third sub-pixel of the first pixel may be smaller than sizes of the first sub-pixel, the second sub-pixel, and the third sub-pixel of the second pixel.

Further examples are set out in the clauses below:
1. A display device comprising:
   a display area in which an auxiliary driving part of an auxiliary pixel is disposed; and
   a bezel area disposed around the display area, in which an auxiliary light emitting part of the auxiliary pixel is disposed,
   wherein the auxiliary light emitting part is electrically connected to the auxiliary driving part.
2. The display device of clause 1, wherein a first pixel is disposed in the display area, the first pixel comprises a first sub-pixel, a second sub-pixel, a third sub-pixel and the auxiliary driving part of the auxiliary pixel,
   wherein the first sub-pixel comprises a first driving part and a first light emitting part electrically connected to the first driving part,
   wherein the second sub-pixel comprises a second driving part and a second light emitting part electrically connected to the second driving part,
   wherein the third sub-pixel comprises a third driving part and a third light emitting part electrically connected to the third driving part, and
   wherein the auxiliary light emitting part of the auxiliary pixel is structurally the same as the first light emitting part, the second light emitting part, or the third light emitting part.
3. The display device of clause 2, wherein the second light emitting part overlaps at least a partial region of the third driving part, and
   wherein the third light emitting part overlaps at least a partial region of the auxiliary driving part.
4. The display device of clause 2, wherein the first pixel includes a plurality of the first sub-pixels, a plurality of the second sub-pixels, and a plurality of the third sub-pixels.
5. The display device of clause 4, wherein the auxiliary driving part includes a first auxiliary driving part, a second auxiliary driving part, and a third auxiliary driving part, and
   wherein the first auxiliary driving part, the second auxiliary driving part, and the third auxiliary driving part are respectively disposed between different sub-pixel groups, each sub-pixel group including the first sub-pixel, the second sub-pixel and the third sub-pixel sequentially.
6. The display device of clause 5, wherein at least one of the first auxiliary driving part, the second auxiliary driving part, and the third auxiliary driving part comprises a driving transistor and a switching transistor.
7. The display device of any of the preceding clauses, wherein the auxiliary driving part of the auxiliary pixel is disposed only in a partial area of a periphery of the display area.
8. The display device of any of the preceding clauses, wherein the auxiliary driving part of the auxiliary pixel is disposed in an entire area including a periphery and a center of the display area.
9. The display device of any of the preceding clauses, wherein the auxiliary driving part of the auxiliary pixel is disposed only in a partial area of a periphery of the display area, and
   wherein a density at which the auxiliary driving part is disposed decreases toward a center of the display area from the periphery.
10. The display device of clause 2, wherein a second pixel including only the first sub-pixel, the second sub-pixel, and the third sub-pixel is further disposed in the display area, and
   wherein a size of the first pixel and a size of the second pixel are the same.
11. The display device of clause 10, wherein sizes of the first sub-pixel, the second sub-pixel, and the third sub-pixel of the first pixel are smaller than sizes of the first sub-pixel, the second sub-pixel, and the third sub-pixel of the second pixel.
12. The display device of clause 9, wherein the first pixel and the second pixel are disposed in a partial area of a periphery of the display area, and another auxiliary light emitting part disposed in the bezel area is electrically connected to one of the first driving part, the second driving part and the third driving part.
13. A display device comprising:
   a substrate including a display area and a bezel area around the display area;
   a first sub-pixel, a second sub-pixel, a third sub-pixel, and an auxiliary driving part of an auxiliary pixel, which are disposed in the display area;
   wherein the first sub-pixel comprises a first driving part and a first light emitting part electrically connected to the first driving part;
   the second sub-pixel comprises a second driving part and a second light emitting part electrically connected to the second driving part; and
   the third sub-pixel comprises a third driving part and a third light emitting part electrically connected to the third driving part,
   wherein an auxiliary light emitting part of the auxiliary pixel is disposed in the bezel area, and
   wherein the auxiliary light emitting part and the auxiliary driving part of the display area are electrically connected.
14. The display device of clause 13, wherein the auxiliary driving part comprises a driving transistor and a switching transistor, and
   wherein the auxiliary light emitting part is structurally the same as the first light emitting part, the second light emitting part, or the third light emitting part.
15. The display device of clause 13, wherein the second light emitting part overlaps at least a partial region of the third driving part, and
   wherein the third light emitting part overlaps at least a partial region of the auxiliary driving part.
16. The display device of clause 13, wherein a first pixel including the first sub-pixel, the second sub-pixel, the third sub-pixel, and the auxiliary driving part of the auxiliary pixel is disposed in the display area, and
   wherein the first pixel includes a plurality of the first sub-pixels, a plurality of the second sub-pixels, and a plurality of the third sub-pixels.
17. The display device of clause 16, wherein the auxiliary driving part includes a first auxiliary driving part, a second auxiliary driving part, and a third auxiliary driving part, and
   wherein the first auxiliary driving part, the second auxiliary driving part, and the third auxiliary driving part are respectively disposed between different sub-pixel groups, each sub-pixel group including the first sub-pixel, the second sub-pixel and the third sub-pixel sequentially.
18. The display device of clause 13, wherein the auxiliary driving part of the auxiliary pixel is disposed only in a partial area of a periphery of the display area.
19. The display device of clause 13, wherein the auxiliary driving part of the auxiliary pixel is disposed in an entire area including a periphery and a center of the display area.
20. The display device of clause 13, wherein the auxiliary driving part of the auxiliary pixel is disposed only in a partial area of a periphery of the display area, and
   wherein a density at which the auxiliary driving part is disposed decreases toward a center of the display area from the periphery.
21. The display device of clause 13, wherein a first pixel including the first sub-pixel, the second sub-pixel, the third sub-pixel, and the auxiliary driving part of the auxiliary pixel is disposed in the display area,
   wherein a second pixel including only the first sub-pixel, the second sub-pixel, and the third sub-pixel is further disposed in the display area, and
   wherein a size of the first pixel and a size of the second pixel are the same.
22. The display device of clause 21, wherein sizes of the first sub-pixel, the second sub-pixel, and the third sub-pixel of the first pixel are smaller than sizes of the first sub-pixel, the second sub-pixel, and the third sub-pixel of the second pixel.

Therefore, the examples described above are to be understood as illustrative in all respects and not restrictive. In addition, the scope of the present disclosure is indicated by the claims to be described later rather than the detailed description. Also, all changes or modified forms derived from the meaning and scope of the claims and their equivalent concepts should be construed as being included in the scope of the present disclosure.

## Claims

1. A display device comprising:
a display area in which an auxiliary driving part of an auxiliary pixel is disposed; and
a bezel area disposed around the display area, in which an auxiliary light emitting part of the auxiliary pixel is disposed,
wherein the auxiliary light emitting part is electrically connected to the auxiliary driving part.

2. The display device of claim 1, wherein a first pixel is disposed in the display area, the first pixel comprises a first sub-pixel, a second sub-pixel, a third sub-pixel and the auxiliary driving part of the auxiliary pixel,
wherein the first sub-pixel comprises a first driving part and a first light emitting part electrically connected to the first driving part,
wherein the second sub-pixel comprises a second driving part and a second light emitting part electrically connected to the second driving part,
wherein the third sub-pixel comprises a third driving part and a third light emitting part electrically connected to the third driving part, and
wherein the auxiliary light emitting part of the auxiliary pixel is structurally the same as the first light emitting part, the second light emitting part, or the third light emitting part.

3. The display device of claim 2, wherein the second light emitting part overlaps at least a partial region of the third driving part, and
wherein the third light emitting part overlaps at least a partial region of the auxiliary driving part.

4. The display device of claim 2, wherein the first pixel includes a plurality of the first sub-pixels, a plurality of the second sub-pixels, and a plurality of the third sub-pixels.

5. The display device of claim 4, wherein the auxiliary driving part includes a first auxiliary driving part, a second auxiliary driving part, and a third auxiliary driving part, and
wherein the first auxiliary driving part, the second auxiliary driving part, and the third auxiliary driving part are respectively disposed between different sub-pixel groups, each sub-pixel group including the first sub-pixel, the second sub-pixel and the third sub-pixel sequentially; and optionally
wherein at least one of the first auxiliary driving part, the second auxiliary driving part, and the third auxiliary driving part comprises a driving transistor and a switching transistor.

6. The display device of any one of the preceding claims, wherein the auxiliary driving part of the auxiliary pixel is disposed only in a partial area of a periphery of the display area; or optionally
wherein the auxiliary driving part of the auxiliary pixel is disposed in an entire area including a periphery and a center of the display area.

7. The display device of any one of the preceding claims, wherein the auxiliary driving part of the auxiliary pixel is disposed only in a partial area of a periphery of the display area, and
wherein a density at which the auxiliary driving part is disposed decreases toward a center of the display area from the periphery.

8. The display device of claim 2, wherein a second pixel including only the first sub-pixel, the second sub-pixel, and the third sub-pixel is further disposed in the display area, and wherein a size of the first pixel and a size of the second pixel are the same; and optionally
wherein sizes of the first sub-pixel, the second sub-pixel, and the third sub-pixel of the first pixel are smaller than sizes of the first sub-pixel, the second sub-pixel, and the third sub-pixel of the second pixel.

9. The display device of claim 7, wherein the first pixel and the second pixel are disposed in a partial area of a periphery of the display area, and another auxiliary light emitting part disposed in the bezel area is electrically connected to one of the first driving part, the second driving part and the third driving part.

10. A display device comprising:
a substrate including a display area and a bezel area around the display area;
a first sub-pixel, a second sub-pixel, a third sub-pixel, and an auxiliary driving part of an auxiliary pixel, which are disposed in the display area;
wherein the first sub-pixel comprises a first driving part and a first light emitting part electrically connected to the first driving part;
the second sub-pixel comprises a second driving part and a second light emitting part electrically connected to the second driving part; and
the third sub-pixel comprises a third driving part and a third light emitting part electrically connected to the third driving part,
wherein an auxiliary light emitting part of the auxiliary pixel is disposed in the bezel area, and
wherein the auxiliary light emitting part and the auxiliary driving part of the display area are electrically connected.

11. The display device of claim 10, wherein the auxiliary driving part comprises a driving transistor and a switching transistor, and
wherein the auxiliary light emitting part is structurally the same as the first light emitting part, the second light emitting part, or the third light emitting part; or optionally
wherein the second light emitting part overlaps at least a partial region of the third driving part, and
wherein the third light emitting part overlaps at least a partial region of the auxiliary driving part.

12. The display device of claim 10, wherein a first pixel including the first sub-pixel, the second sub-pixel, the third sub-pixel, and the auxiliary driving part of the auxiliary pixel is disposed in the display area, and
wherein the first pixel includes a plurality of the first sub-pixels, a plurality of the second sub-pixels, and a plurality of the third sub-pixels; and optionally
wherein the auxiliary driving part includes a first auxiliary driving part, a second auxiliary driving part, and a third auxiliary driving part, and
wherein the first auxiliary driving part, the second auxiliary driving part, and the third auxiliary driving part are respectively disposed between different sub-pixel groups, each sub-pixel group including the first sub-pixel, the second sub-pixel and the third sub-pixel sequentially.

13. The display device of claim 10, wherein the auxiliary driving part of the auxiliary pixel is disposed only in a partial area of a periphery of the display area; or optionally
wherein the auxiliary driving part of the auxiliary pixel is disposed in an entire area including a periphery and a center of the display area; or optionally
wherein the auxiliary driving part of the auxiliary pixel is disposed only in a partial area of a periphery of the display area, and
wherein a density at which the auxiliary driving part is disposed decreases toward a center of the display area from the periphery.

14. The display device of claim 10, wherein a first pixel including the first sub-pixel, the second sub-pixel, the third sub-pixel, and the auxiliary driving part of the auxiliary pixel is disposed in the display area,
wherein a second pixel including only the first sub-pixel, the second sub-pixel, and the third sub-pixel is further disposed in the display area, and
wherein a size of the first pixel and a size of the second pixel are the same.

15. The display device of claim 14, wherein sizes of the first sub-pixel, the second sub-pixel, and the third sub-pixel of the first pixel are smaller than sizes of the first sub-pixel, the second sub-pixel, and the third sub-pixel of the second pixel.
